# EUROPEAN PATENT APPLICATION

(11) **EP 2 071 684 A1**
(43) Date of publication of application: **17.06.2009**
(21) Application number: 08160479.5
(22) Date of filing: 16.07.2008
(51) Int. Cl.: H01S 5/068, H01S 5/0683, H01S 5/0687, H01S 5/14

(54) **Laser diode with shutter opened only for stabilized wavelength**

(30) Priority: 14.12.2007 JP 2007323505
(71) Applicant: Tecdia Co., Ltd., Tokyo 170-6020 (JP)
(72) Inventor: Koyama, Etsuo, Tokyo 170-6020 (JP); Nagai, Yasuo, Tokyo 170-6020 (JP)
(74) Representative: Brötz, Helmut

(57) **Abstract**

The objective of the present invention is to provide with is to provide with a tunable laser module capable of adequately detecting the decay of the large variation in the wavelength of the light and then operating the shutter. The tunable laser module 1 comprises a tunable laser source 11∼13 capable of emitting light with a wavelength defined by wavelength control signal, and following controllers 14∼17, 18∼23, 24∼28. A temperature controller 14∼17 operates to perform the control of the temperature of the tunable laser source 11∼13. A wavelength controller 18∼23 operates to perform the control of the wavelength of the light emanating from the tunable laser source 11∼13. A power controller 24∼28 operates to perform the control of the power of the tunable laser source 11∼13. The tunable laser module 1 further comprises a stability discriminator 29, optical switch 30, 31, an optical terminator 32 for absorbing light entering herein, and an optical connector 33 for coupling its incident light with an external transmission line. The stability discriminator 29 discriminates whether the wavelength and the temperature are stable or not, based on both temperature control signal and wavelength control signal. When having discriminated that their stability was achieved, the discriminator 29 generates enable signal. The optical switch 30, 31 is capable of switching the optical path of the light emanating therefrom when receiving the enable signal.

## Description

### BACKGROUND OF THE INVENTION

### Technical Field

The present invention relates to a tunable laser module selectively tunable a wavelength of its emitting light and usable to the DWDM (Dense Wavelength Division Multiplexing) communication system and so on.

### Description of Related Art

Regarding a tunable laser module, a finite response time is accompanied with each component, such as, a gain medium, a tunable wavelength device, a controller. It is known therefore that fatal events may be caused to the system by entering the light emanating from the laser module in the unstable state. In such as a long-distance DWDM application, the module is generally used at almost full power. Therefore, there may be caused cross-channel interference (for example, between near channels), undesired signal to these channels, obstacles as well as damages to the system, and so on.

To avoid this, its normal operation usually starts after the stabilization for a certain time; unless the stability being achieved, the light is blocked, for example, by a shutter for shutting off the optical path (refer, for example, Patent document 1.). In the Patent document 1, there is described a laser module having an optical detector and a controller. The optical detector detects the wavelength and the power of the light branched off by a beam splitter positioned on the optical path; and the controller controls the wavelength and the power of the light. The module switches the shutter to transmit or shut off the light in response to the signal from the controller.

[Patent document 1] Japanese Patent Application Laid-Open Publication No. 2006-210581

However, in the patent document 1, there is no concrete description or suggestion regarding a method for controlling the shutter, therefore it is unknown how to appropriately operate the shutter. Particularly, it is not possible to adequately operate the shutter by detecting the decay of the large variation in, such as, the wavelength in the transient state.

### SUMMARY OF THE INVENTION

Considering the aforementioned state of art, the objective of the present invention is to provide with a tunable laser module capable of adequately detecting the decay of the large variation in the wavelength of the light and then operating the shutter.

The present invention provides following configurations in order to achieve the aforementioned objective.
(1) The invention of claim 1 provides with a tunable laser module, comprising: a tunable laser source externally supplied with light and capable of, in a tunable manner, emitting the light with a wavelength corresponding to wavelength control signal representing a target wavelength to which the wavelength is directed; a wavelength controller for detecting the wavelength of the light emanating from the tunable laser source and then generating the wavelength control signal; a temperature controller for detecting the temperature of the tunable laser source and then generating temperature control signal representing a target temperature to which the temperature is directed; an optical switch capable of switching the optical path of the light emanating from the tunable laser source or blocking the light or transmitting the light when having externally input enable signal; and a stability discriminator for performing discrimination of the stability of the wavelength, the discrimination including that on whether the moving average of the wavelength control signal converges within a certain range during a certain time interval or not, and then generating the enable signal when having discriminated that stable state having been achieved, based on the discrimination of the stability.

(2) The invention of claim 2 provides with the tunable laser module as claimed in claim 1, further comprising: a power controller for detecting output power of the tunable laser source and then generating power control signal representing a target power to which the power is directed.

(3) The invention of claim 3 provides with the tunable laser module as claimed in claim 1 or claim 2, wherein the stability discriminator calculates moving averages of the wavelength control signal for a plurality of different sampling interval sets and then discriminates in the order from the longest sampling interval to the shortest one whether each moving average converges within a certain range or not.

According to the invention of claim 1, it is possible to provide with a tunable laser module capable of adequately detecting the decay of the large variation in the wavelength of the light and then operating the shutter. This is supported by the fact that the tunable laser module of claim1 comprises the tunable laser source, the wavelength controller, the temperature controller, the optical switch, and the stability discriminator that configured as follows. Here the tunable laser source is externally supplied with light and is capable of, in a tunable manner, emitting the light with a wavelength corresponding to wavelength control signal representing a target wavelength to which the wavelength is directed. The wavelength controller operates to detect the wavelength of the light emanating from the tunable laser source and then generate the wavelength control signal. The temperature controller operates to detect the temperature of the tunable laser source and then generate temperature control signal representing a target temperature to which the temperature is directed. The optical switch is capable of switching the optical path of the light emanating from the tunable laser source or blocking the light or transmitting the light when having externally input enable signal. The stability discriminator for performing discrimination of the stability of the wavelength, the discrimination including that on whether the moving average of the wavelength control signal converges within a certain range during a certain time interval or not, and then generating the enable signal when having discriminated that stable state having been achieved, based on the discrimination of the stability.

According to the invention of claim 2, in addition to the aforementioned advantage of the invention claimed in claim 1, it is further possible to ensure the stability of the power. This is supported by the fact that the tunable laser module of claim2 further comprises the power controller for detecting output power of the tunable laser source and then generating power control signal representing a target power to which the power is directed.

According to the invention of claim 3, in addition to the aforementioned advantage of the invention claimed in claim 1 or claim 2, it is further possible to adaptively control in responsive to the unstable condition. This is supported by the fact that the stability discriminator of the tunable laser module of claim 3 calculates moving averages of the wavelength control signal for a plurality of different sampling interval sets and then discriminates in the order from the longest sampling interval to the shortest one whether each moving average converges within a certain range or not.

### BRIEF DESCRIPTION OF THE DRAWINGS

FIG. 1 is a block diagram schematically illustrating an exemplary tunable laser module according to the present invention.
FIG. 2 is a view schematically illustrating a graph for explaining the discrimination of the wavelength stability, the discrimination being one of the examples those performed by the stability discriminator.

### DETAILED DESCRIPTION OF THE PREFERRED EMBODIMENTS

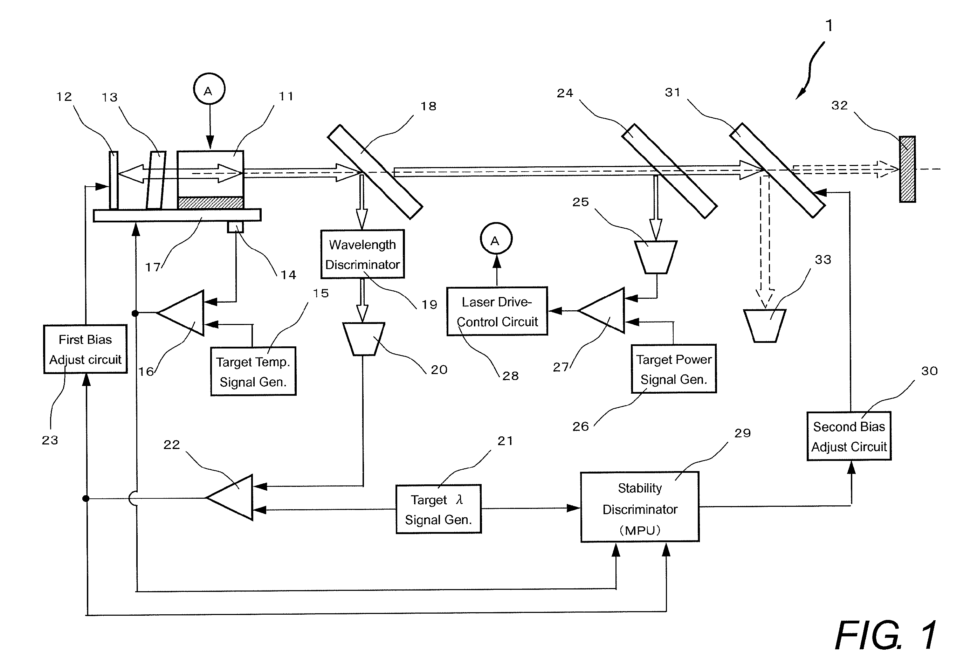

Hereinafter, referring to the accompanying drawings illustrating exemplary configurations, descriptions are made on embodiments according to the present invention. FIG. 1 is a block diagram schematically illustrating an exemplary tunable laser module according to the present invention. The tunable laser module 1 comprises, as shown in FIG. 1, a tunable laser source 11∼13 capable of emitting light with a wavelength defined by wavelength control signal, and following controllers 14∼17, 18∼23, 24-28. One of the controllers is a temperature controller 14-17 for performing temperature control, in which the temperature of the tunable laser source 11∼13 is detected and then is controlled toward a target temperature. The next one is a wavelength controller 18∼23 for performing wavelength control, in which the wavelength of the light emanating from the tunable laser source 11∼13 is detected and is controlled toward a target wavelength. The last one is a power controller 24-28 for performing power control, in which the power of the tunable laser source 11∼13 is detected and then is controlled toward a target power. The tunable laser module 1 further comprises a stability discriminator 29, optical switch 30, 31, an optical terminator 32 for absorbing light entering herein, and an optical connector 33 for coupling its incident light with an external transmission line. The stability discriminator 29 discriminates whether the wavelength and the temperature are stable or not, based on control signal from the temperature controller 14∼17 and the wavelength controller 18∼23. When having discriminated that their stability was achieved, the discriminator 29 generates enable signal. The optical switch 30, 31 is capable of switching the optical path of the light emanating therefrom when receiving the enable signal.

The tunable laser source 11∼13 is usable, for example, as an optical source for an optical communication system and has a gain medium 11, a tunable band rejector 12, and an etalon 13. The gain medium 11 is capable of amplifying light within a wavelength band including a desired wavelength. The tunable band rejector 12 is positioned opposite the gain medium 11; and the etalon 13 is positioned between the gain medium 11 and the tunable band rejector 12.

The gain medium 11 consists of, such as a semiconductor optical amplifier, an optical fiber amplifier and is capable of amplifying light within the communication band. The etalon 13 has transmission property, in which certain target wavelengths including the desired wavelength selectively transmit therethrough. The tunable band rejector 12 selectively rejects a light with the target wavelength from its incident light while transmitting the remaining. The tunable band rejector 12 may consist of, such as, a liquid crystal device capable of altering its target wavelength by adjusting the applied voltage. Further specifically, "Tunable wavelength liquid crystal filter" obtainable from TECDIA co. ltd. is available as the tunable band rejector 12.

The temperature controller 14∼17 has a temperature sensor 14 consisting of such as a thermo-couple, a target temperature signal generator 15, a first operational amplifier 16, and a Thermo-Electric Cooler (TEC) 17. The target temperature signal generator 15 generates target temperature signal consisting of, such as, voltage signal for obtaining the target temperature at the temperature sensor 14. The first operational amplifier 16 outputs temperature control signal depending on the difference between the output of the temperature sensor 14 and that of the target temperature signal generator 15. The TEC 17 adjusts the temperature of the tunable laser source 11∼13 in response to the temperature control signal from the first operational amplifier 16.

The wavelength controller 18∼23 has a first beam splitter 18, a wavelength discriminator 19, a first optical detector 20, a target wavelength signal generator 21, a second operational amplifier 22, and a first bias adjust circuit 23. The first beam splitter 18 branches off a part of the light emanating from the tunable laser source 11∼13 for monitor use. The wavelength discriminator 19 consists of, such as, an etalon with a transmission spectrum enabling the discrimination of the wavelength of the branched off light by way of its transmitted light power. The first optical detector 20 outputs output signal consisting of, such as, voltage signal representing the power level, i.e., the wavelength of the light from the wavelength discriminator 19. The target wavelength signal generator 21 generates target wavelength signal consisting of, such as, voltage signal for obtaining voltage corresponding to the target wavelength at the first optical detector 20. The second operational amplifier 22 outputs wavelength deviation signal depending on the difference between the output of the first optical detector 20 and that of the target wavelength signal generator 21. The first bias adjust circuit 23 generates voltage signal as the wavelength control signal to be applied to the tunable band rejector 12 depending on the wavelength deviation signal from the second operational amplifier 22.

The power controller 24∼28 a second beam splitter 24, a second optical detector 25, a target power signal generator 26, a third operational amplifier 27, and a laser drive-control circuit 28. The second beam splitter 24 branches off a part of the light that emanated from the tunable laser source 11∼13 and then transmitted the first beam splitter 18, for power monitor use. The second optical detector 25 outputs output signal consisting of, such as, voltage signal representing the level of the light branched off by the second beam splitter 24. The target power signal generator 26 outputs target power signal consisting of, such as, voltage signal for obtaining voltage corresponding to the target wavelength at the second optical detector 25. The third operational amplifier 27 compares the output from the second optical detector 25 with that of the target power signal generator 26 and then outputs power control signal depending on their difference. The laser drive-control circuit 28 generates voltage signal for applying to the gain medium 11 depending on the power control signal from the third operational amplifier 27.

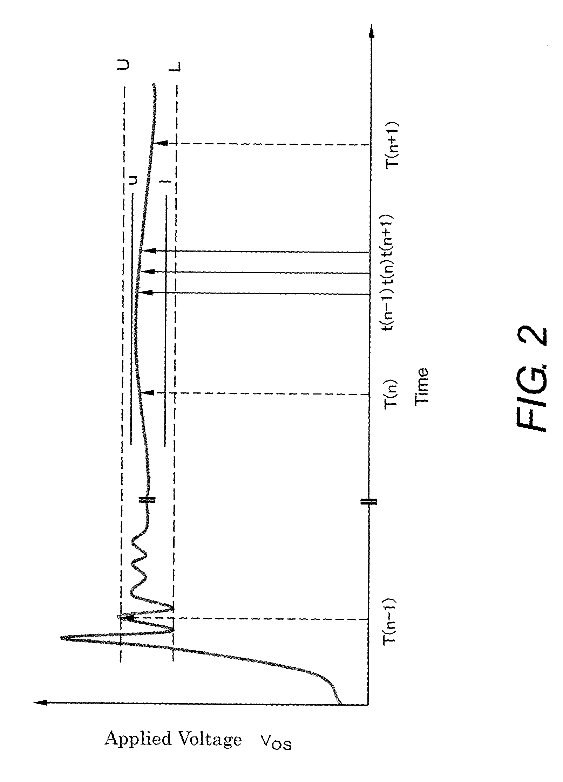

The stability discriminator 29 discriminates the temperature stability of the tunable laser source 11∼13 and the wavelength stability based on the temperature control signal from the first operational amplifier 16 and the wavelength control signal from the second operational amplifier 22, for example, as follows. FIG. 2 is a view schematically illustrating a graph for explaining the discrimination of the wavelength stability, the discrimination being one of the examples those performed by the stability discriminator 29. In FIG. 2, the voltage applied to the tunable band rejector 12 is shown along the ordinate, and the time along the abscissa.

The voltage applied to the tunable band rejector 12 differs depending on, such as, control system parameters, system to be controlled and so on and behaves as shown, for example, in FIG. 2. The stability discriminator 29 calculates, prior to the discrimination, moving averages of the wavelength deviation signal from the second operational amplifier 22, i.e., the signal corresponding to the applied voltage shown in FIG. 2.

In such a system, it is often that a transient state with a large variation in the voltage lasts for a long time. Therefore, it may happen that in this state, the discrimination is not adequately achievable based on the deviation from the target wavelength. Accordingly, in the present invention, the deviations of the moving averages from the target wavelength are used to the discrimination in the unstable state, such as, the unstable transient state.

Hereat, the moving averages are performed using a plurality of different sampling interval sets, for example, those shown in FIG. 2: a long interval set defined the time series T(n-1), T(n), and T(n+1), and a short interval set defined the time series t(n-1), t(n), and t(n-1). The longer sampling interval is defined depending on, for example, the order of the response time of the transient state. By using a plurality of sampling interval sets, it is possible to detect the magnitudes of the deviations in the transient state at different time scales.

Further, the stability discriminator 29 may be configured to switch the optical switch 30, 31 on by outputting the enable signal after the moving averages, in other words the deviations, converge as follows. Firstly the average with the longer sampling interval converges within a certain first range (for example, within the range limited by the lines U and L shown in FIG. 2). Then the average with the shorter sampling interval converges within a certain second range (for example, within the range limited by the lines u and I shown in FIG. 2).

Furthermore, the stability discriminator 29 may also be configured to switch the optical switch 30, 31 on by outputting the enable signal after the moving average and deviations converge as follows. Firstly the average with the longer sampling interval converges within the first range. Subsequently the deviations from the target wavelength are detected at another shorter sampling interval and converge within a certain range thereafter. In this case, the moving average with the former shorter sampling interval may also be performed in addition to the above longer moving average.

Here, the sampling interval and the number of sampling points are defined depending on, such as, the system to be controlled. As to the stability discriminations performed by the stability discriminator 29, the temperature may firstly be examined whether it is stable within a certain range or not. Therefore, after the temperature stability being achieved, the discrimination is performed on whether the wavelength converges in a certain range.

Hereat, regarding the discrimination criteria of the stability, they depend on such as the sampling interval and so on as can be seen in FIG. 2. Further, the discriminations of the stability may also be performed in the following order: at first, regarding the temperature of the individual elements/ devices composing the tunable laser source 11∼13 or of the whole source, next, regarding the output of the laser drive-control circuit 28, and subsequently regarding the wavelength after achieving the stability of the output of this 28.

The optical switch 30, 31 have a second bias adjust circuit 30 and a shutter 31. The second bias adjust circuit 30 switches bias voltage on receiving the enable/ disable signal. The shutter 31 consists of, such as, a liquid crystal device and switches the optical path of the light emanating from the tunable laser source 11∼13 in response to the bias voltage change.

Here, in the configuration that the shutter 31 consists of the liquid crystal, the bias voltage may be AC and further switched from the higher first AC value to the lower second AC value by the input enable signal. Further, the shutter 31 is considered to be switched by entering the enable signal, from the open state to the close state, i.e., the reflection state. Further, the shutter 31 consists of an electric shutter working in response to the applied voltage, a BRF (Band Rejection Filter) consisting of a liquid crystal device, or the other optical device capable of switching the optical path.

In the present embodiment, the shutter 31 opens during the unstable state; and the optical terminator 32 is provided with to absorb the light incident after transmitting through the shutter 31. Therefore, in the stable state, the optical path of the light emanating from the tunable laser source 11∼13 is switched or reflected; thereby the light enters on the optical connector 33, and then propagating into the external transmission line not shown. However, it is also possible to configure that the optical connector 33 and the optical terminal 32 are replaced each other and the shutter works in the opposite way from what is described above.

The tunable laser module according to the present invention is usable as an optical source in the field where the capability of selectively tuning the wavelength is advantageous, such as, in the field of DWDM communication.

## Claims

1. A tunable laser module, comprising:
a tunable laser source externally supplied with light and capable of, in a tunable manner, emitting the light with a wavelength corresponding to wavelength control signal representing a target wavelength to which the wavelength is directed;
a wavelength controller for detecting the wavelength of the light emanating from said tunable laser source and then generating the wavelength control signal;
a temperature controller for detecting the temperature of said tunable laser source and then generating temperature control signal representing a target temperature to which the temperature is directed;
an optical switch capable of switching the optical path of the light emanating from said tunable laser source or blocking said light or transmitting said light when having externally input enable signal; and
a stability discriminator for performing discrimination of the stability of the wavelength, the discrimination including that on whether the moving average of the wavelength control signal converges within a certain range during a certain time interval or not, and then generating said enable signal when having discriminated that stable state having been achieved, based on the discrimination of the stability.

2. The tunable laser module as claimed in claim 1, further comprising: a power controller for detecting output power of said tunable laser source and then generating power control signal representing a target power to which the power is directed.

3. The tunable laser module as claimed in claim 1 or claim 2, wherein said stability discriminator calculates moving averages of the wavelength control signal for a plurality of different sampling interval sets and then discriminates in the order from the longest sampling interval to the shortest one whether each moving average converges within a certain range or not.
